# EUROPEAN PATENT SPECIFICATION

(11) **EP 2 581 951 B1**
(45) Date of publication and mention of the grant of the patent: **18.06.2014**
(21) Application number: 12187980.3
(22) Date of filing: 10.10.2012
(51) Int. Cl.: H01L 31/18

(54) **MEthod and apparatus for the formation of solar cells with selective emitters**
Verfahren und Vorrichtung zur Formung von Solarzellen mit selektiven Emittern
Procédé et appareil pour la formation de cellules solaires avec des émetteurs sélectifs

(30) Priority: 13.10.2011 IT UD20110162
(43) Date of publication of application: 17.04.2013
(73) Proprietor: APPLIED MATERIALS ITALIA S.R.L., 31048 San Biagio di Callalta (TV) (IT)
(72) Inventor: Budiarto, Edward, Fremont, CA California 94539 (US); Egan, Todd, Fremont, CA California 94536 (US)
(74) Representative: Zimmermann & Partner

(56) References cited:
- US-A1- 2011 003 465
- US-A1- 2011 003 466
- US-A1- 2011 025 839

## Description

### BACKGROUND OF THE INVENTION

### Field of the Invention

Embodiments of the invention relate to methods for the forming solar cells with selective emitters, in particular for aligning selective emitter regions and a screen printing pattern to make solar cells with a crystalline silicon base.

### Description of the Related Art

Solar cells are photovoltaic (PV) devices that convert sunlight directly into electrical power. The PV market has experienced growth at annual rates exceeding 30% for the last ten years. Some articles suggest that solar cell power production world-wide may exceed 10 GWp in the near future. It is estimated that more than 95% of all solar modules are silicon wafer based. The high market growth rate in combination with the need to substantially reduce solar electricity costs has resulted in a number of serious challenges for inexpensively forming high quality solar cells. Therefore, one major component in making commercially viable solar cells lies in reducing the manufacturing costs required to form the solar cells by improving the device yield and increasing the substrate throughput. Documents US 2011/003466 A and US 2011/003465 A describe methods to manufacture solar cells.

Solar cells typically have one or more p-n junctions. Each p-n junction comprises two different regions within a semiconductor material where one side is denoted as the p-type region and the other as the n-type region. When the p-n junction of a solar cell is exposed to sunlight (consisting of energy from photons), the sunlight is directly converted to electricity through the PV effect. Solar cells generate a specific amount of electrical power and are tiled into modules sized to deliver the desired amount of system power. Solar modules are joined into panels with specific frames and connectors. Solar cells are commonly formed on silicon substrates, which may be single or multicrystalline silicon substrates. A typical solar cell includes a silicon wafer, substrate, or sheet typically less than about 0.3 mm thick with a thin layer of n-type silicon on top of a p-type region formed on the substrate.

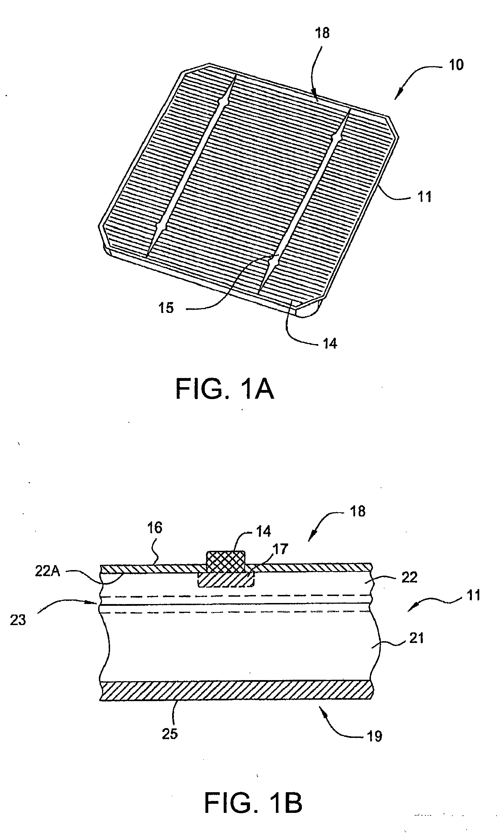

Figs. 1A and 1B schematically depict a standard silicon solar cell 10 fabricated on a wafer 11. The wafer 11 includes a p-type base region 21, an n-type emitter region 22, and a p-n junction region 23 disposed therebetween. An n-type region, or n-type semiconductor, is formed by doping the semiconductor with certain types of elements (e.g. phosphorous (P), arsenic (As) or antimony (Sb)), in order to increase the number of negative charge carriers, i.e. electrons. Similarly, a p-type region, or p-type semiconductor, is formed by the addition of trivalent atoms to the crystal lattice, resulting in a missing electron from one of the four covalent bonds normal for the silicon lattice. Thus the dopant atom can accept an electron from a neighboring atoms covalent bond to complete the fourth bond. The dopant atom accepts an electron, causing the loss of half of one bond from the neighboring atom and resulting in the formation of a "hole."

When light falls on the solar cell, energy from the incident photons generates electron-hole pairs on both sides of the p-n junction region 23. Electrons diffuse across the p-n junction to a lower energy level, and holes diffuse in the opposite direction, creating a negative charge on the emitter and a corresponding positive charge builds up in the base. When an electrical circuit is made between the emitter and the base and the p-n junction is exposed to certain wavelengths of light, a current will flow. The electrical current generated by the semiconductor when illuminated flows through contacts disposed on the frontside 18, i.e. the light-receiving side, and the backside 19 of the solar cell 10. The top contact structure, as shown in Fig. 1A, is generally configured as widely-spaced thin metal lines, or fingers 14, that supply current to a larger busbar 15. A back contact 25 is generally not constrained to be formed in multiple thin metal lines, since it does not prevent incident light from striking solar cell 10. Solar cell 10 is generally covered with a thin layer of dielectric material, such as Si3N4, to act as an antireflection coating 16, or ARC, to minimize light reflection from a top surface 22A of solar cell 10.

Screen printing has long been used in printing designs on objects, such as cloth or ceramics, and is used in the electronics industry for printing electrical component designs, such as electrical contacts or interconnects on the surface of a substrate. State of the art solar cell fabrication processes also use screen printing processes. In some applications, it is desirable to screen print contact lines, such as fingers 14, on the solar cell substrate. The fingers 14 are in contact with the substrate and are able to form an Ohmic connection with one or more doped regions (e.g. n-type emitter region 22). An Ohmic contact is a region on a semiconductor device that has been prepared so that the current-voltage (I-V) curve of the device is linear and symmetric, i.e., there is no high-resistance interface between the doped silicon region of the semiconductor device and the metal contact. Low resistance, stable contacts are critical for the performance of the solar cell and reliability of the circuits formed in the solar cell fabrication process. To enhance the contact with the solar cell device it is typical to position the finger 14 on a heavily doped region 17 formed within the substrate surface to enable the formation of an Ohmic contact. Since the formed heavily doped regions 17, due to their electrical properties, tend to block or minimize the amount of light that can pass there through, it is desirable to minimize their size, while also making these regions large enough to assure that the fingers 14 can be reliably aligned and formed thereon. The misalignment of the deposited fingers 14 to the underlying heavily doped regions 17 due to errors in the positioning of the substrate on an automated transferring device, defects in the edge of the substrate, unknown registration and alignment of the heavily doped region 17 on the substrate surface and/or shifting of the substrate on the automated transferring device, can lead to a poor device performance and a low device efficiency. A vision system for screen printing pattern alignment is described in the application WO-A-2010/068331. Heavily doped regions 17 may be formed on the substrate surface using a variety of patterning techniques to create areas of heavier and lighter doping, for example by performing phosphorous diffusion steps using a patterned diffusion barrier. A backside contact completes the electrical circuit required for solar cell to produce a current by forming an Ohmic contact with p-type base region of the substrate.

In this field, it is known to produce solar cells with a crystalline silicon base by means of the cited technique of screen printing, achieving a structure of selective emitters 22A on the front surface of the solar cells. The selective emitters are formed by a deposit, using a screen printing operation, of a pattern of lines of selective emitters (SE), normally about 150 mm wide, heavily phosphorous-doped, or with a high concentration (about 10²⁰ atoms/cm³), on a phosphorous-doped layer with a lower concentration (about 10¹⁹ atoms/cm³), which constitutes the emitter region. The pitch, or reciprocal distance, of the SE lines is about 1.7 mm. After depositing an antireflection coating film (ARC) based on nitride, the metal contact lines are deposited with a desired pattern, generally 100 mm wide, on top of the SE lines, by means of another screen printing operation. The search for great efficiency of solar cells requires that the metal contact lines are aligned precisely so as to overlap over the SE lines. Consequently, a high resolution image of the SE lines is required, in order to establish the position of the SE lines before printing the metal contact lines. The contrast mechanism adopted for the analysis of the images exploits the different dopant concentration, i.e., the difference between the heavily doped SE lines surrounded by the weakly doped emitter regions which generally cannot be detected by the conventional optical techniques of image analysis which operate in the wavelength of the visible. It is desirable, for a successful technique for controlling the alignment using images, that it is sensitive to the different dopant concentration.

Alternatively, some processes for producing selective emitters can induce topographical differences between the SE lines and the emitter regions, given by the different surface texture or steps of different height, which allow to execute more traditional optical techniques of image analysis.

Furthermore, the solar cell can have a mono- or poly-crystalline silicon base, and this adds a further difficulty because in poly-crystalline silicon there are regions with different orientations of the silicon grains, which can vary the quantity of reflected light and hence obscure the contrast of the SE lines.

The purpose of at least one embodiment of the invention is to achieve a method for aligning selective emitters of a screen printing pattern in the formation of solar cells with a crystalline silicon base by optical imaging, which supplies high resolution images of the SE lines in order to establish the position of the SE lines before printing the metal contact lines, so that their alignment is precise and reliable, giving the advantage of a higher efficiency of the solar cells thus obtained.

The Applicant has devised, tested and embodied the invention to overcome the shortcomings of the state of the art and to obtain these and other purposes and advantages.

### SUMMARY OF THE INVENTION

According to one embodiment of the invention, a method for forming solar cells with selective emitters comprises: positioning a substrate on a substrate receiving surface, wherein the substrate has a surface with at least a first patterned heavily doped region made on said surface, with a first dopant concentration that defines the selective emitters, surrounded by a second doped emitter region having a second dopant concentration, lower than the first dopant concentration; determining the actual position of the first patterned heavily doped region on the substrate, wherein determining the actual position comprises: the acquisition of an optical image of a portion of the surface; the optical filtering of the optical image; the Fourier transform processing of the optical image subjected to filtering; the evaluation of the contrast in the optical image subjected to filtering and Fourier transform processing, between the first heavily doped region and the second doped emitter region; aligning one or more distinctive elements in a screen printing mask with the first patterned heavily doped region using information received from the determined actual position of the first patterned heavily doped region on the substrate; and depositing a layer of material on at least a portion of the first patterned heavily doped region after aligning the one or more distinctive elements to the first patterned heavily doped region, in order to define a metal conducting layer.

In some embodiments, the Fourier transform processing involves: Fourier transform of the optically filtered image; selecting and highlighting features of the image in the Fourier transform space belonging to the first heavily doped region thereby filtering out unwanted background image to obtain a filtered Fourier transform image; Inverse Fourier transform the filtered Fourier transform image to create the final image with higher contrast between the first heavily doped region and the second doped emitter region.

In some embodiments, the acquisition of the optical image of a portion of the surface provides the reception of electromagnetic radiation on a first wavelength in a restricted sub-range of the field of the visible light arriving from the surface.

In other embodiments, the acquisition of the optical image of a portion of the surface provides the reception of electromagnetic radiation on a first wavelength in a restricted sub-range of the field of the infrared wavelengths arriving from the surface.

Thus, the Fourier transform processing can be applied to both the visible and the infrared images. Fourier transform processing enhances the contrast between the selective emitters lines and the surrounding emitter region. In the infrared, Fourier transform processing can be advantageously used if the infrared contrast is not sufficient.

According to another embodiment of the invention, a method for the formation of solar cells with selective emitters according to the invention comprises: positioning a substrate on a substrate receiving surface, wherein the substrate has a surface with at least a first patterned heavily doped region made on said surface, with a first dopant concentration that defines the selective emitters, surrounded by a second doped emitter region having a second dopant concentration, lower than the first dopant concentration; determining the actual position of the first patterned heavily doped region on the substrate, in which determining the actual position comprises: the acquisition of an optical image of a portion of the surface, which provides the reception of electromagnetic radiation on a first wavelength in the long wave infrared spectrum equal to, or longer than, about 8 microns (µm) arriving from the surface; the evaluation of the contrast in the optical image between the first patterned heavily doped region and the second doped emitter region; aligning one or more distinctive elements in a screen printing mask with the first patterned heavily doped region using information received from the determined actual position of the first patterned heavily doped region on the substrate; and depositing a layer of material on at least a portion of the first patterned heavily doped region after aligning one or more distinctive elements to the first patterned heavily doped region, in order to define a metal conducting layer.

In some embodiments, the first wavelength arriving from the surface in the long wave infrared spectrum is between about 8 µm and 14 µm.

Wavelengths longer than 14 µm are generally more advantageous, but the range between about 8 µm and 14 µm provides an acceptable compromise between costs of the now commercially available long-wave infrared cameras, that have upper detection limits, and performance, without excluding, for the purposes of the present invention, the use of possible cameras that can operate at longer wavelengths.

In some embodiments, the method according to the invention comprises: depositing a first dopant material having first dopant atoms with a first dopant concentration in a pattern on a surface of a substrate; heating the substrate and the first dopant material in order to determine the diffusion of dopant atoms of the first dopant material in the surface, and obtaining a first patterned heavily doped region which defines the selective emitters; depositing, in the regions of the surface of the substrate between the first dopant material deposited, a second dopant material having second dopant atoms with a second dopant concentration, lower than the first dopant concentration, so as to define a second doped emitter region.

In some variants, the first dopant atoms and the second dopant atoms are selected from a group of elements comprising phosphorous, arsenic, antimony, boron, aluminum and gallium.

According to some variants of the invention, the first dopant atoms and the second dopant atoms are the same type of dopant atoms.

In some embodiments, the layer deposited on at least one portion of the first patterned heavily doped region comprises a conductive material, the substrate comprises silicon and the first patterned heavily doped region has a dopant concentration greater than about 1018 atoms/cm3.

In some embodiments, the reception of electromagnetic radiation is achieved by an optical detector which is positioned adjacent to the surface.

In some embodiments, the acquisition of an optical image of a portion of the surface provides to emit electromagnetic radiation toward the surface.

In some embodiments, the acquisition of the optical image of a portion of the surface also comprises the detection of the difference in intensity of the electromagnetic radiation reflected by the portion of the first patterned heavily doped region and by the second doped emitter region.

In some embodiments, the reception of electromagnetic radiation arriving from the surface of the substrate provides to detect the infrared radiation emitted by the substrate supplied at a temperature higher than ambient temperature.

The invention also concerns an apparatus for the formation of solar cells with selective emitters which in one embodiment comprises: a support surface for a substrate having a surface with a first patterned heavily doped region made on the surface, with a first dopant concentration and which defines the selective emitters, surrounded by a second doped emitter region having a second dopant concentration, lower than the first dopant concentration; a detector assembly that is configured for: the acquisition of an optical image of a portion of the surface; the optical filtering of the optical image; a deposition chamber having a screen printing mask and at least an actuator which is configured to position the screen printing mask; a controller configured for: the reception of the optical image subjected to filtering by the detector assembly; the Fourier transform processing of the optical image subjected to filtering; the evaluation of the contrast in the optical image subjected to filtering and Fourier transform processing, between the first heavily doped region and the second doped emitter region; and the adjustment of the position of the screen printing mask with respect to the first patterned heavily doped region according to said evaluation.

In another embodiment, an apparatus for the formation of solar cells with selective emitters according to the invention comprises: a substrate support surface having a surface with a first patterned heavily doped region made on the surface, with a first dopant concentration and which defines the selective emitters, surrounded by a second doped emitter region having a second dopant concentration, lower than the first dopant concentration; a detector assembly configured for the acquisition of an optical image of a portion of the surface, by means of the reception of electromagnetic radiation on a first wavelength in the long wave infrared spectrum equal to, or longer than, about 8 µm arriving from the surface; a deposition chamber having a screen printing mask and at least an actuator which is configured to position the screen printing mask; a controller configured for: the reception of the optical image from the detector assembly; the evaluation of the contrast in the optical image between the first heavily doped region and the second doped emitter region; the adjustment of the position of the screen printing mask with respect to the first patterned heavily doped region according to said evaluation.

In variant embodiments, the apparatus according to the invention comprises an electromagnetic radiation source which is positioned to emit electromagnetic radiation toward the surface of the substrate.

In some embodiments, the detector assembly comprises a camera.

In variant embodiments, the detector assembly comprises at least an optical filter disposed between the surface and the camera, in which the optical filter is able to allow the first wavelength to pass through it.

### BRIEF DESCRIPTION OF THE DRAWINGS

These and other characteristics of the invention will become apparent from the following description of a preferential embodiment, given as a non-restrictive example with reference to the attached drawings wherein:
Figure 1A is an isometric view of a prior art solar cell containing a metalized interconnect pattern;
Figure 1B is a side cross-sectional view of the prior art solar cell shown in Figure 1A;
Figures 2A-2D are side cross-sectional views of a solar cell substrate during a processing sequence used to form the selective emitter and active regions of a solar cell device;
Figure 3A is a schematic isometric view of a system that can be used in conjunction with embodiments of the invention to form multiple layers of a desired pattern;
Figure 3B is a schematic top plan view of the system in Figure 3A according to one embodiment of the invention;
Figure 3C is an isometric view of a printing nest portion of the screen printing system according to one embodiment of the invention;
Figure 3D is a schematic isometric view of one embodiment of a rotary actuator assembly having an inspection assembly positioned to inspect the front surface of the substrate according to one embodiment of the invention;
Figure 4A is a schematic cross-sectional view of an optical inspection system according to one embodiment of the invention;
Figure 4B is a schematic cross-sectional view of an optical inspection system positioned in a printing nest according to one embodiment of the invention;
Figure 5 illustrates a flow chart of a method for forming the active regions of Figures 2A-2D;

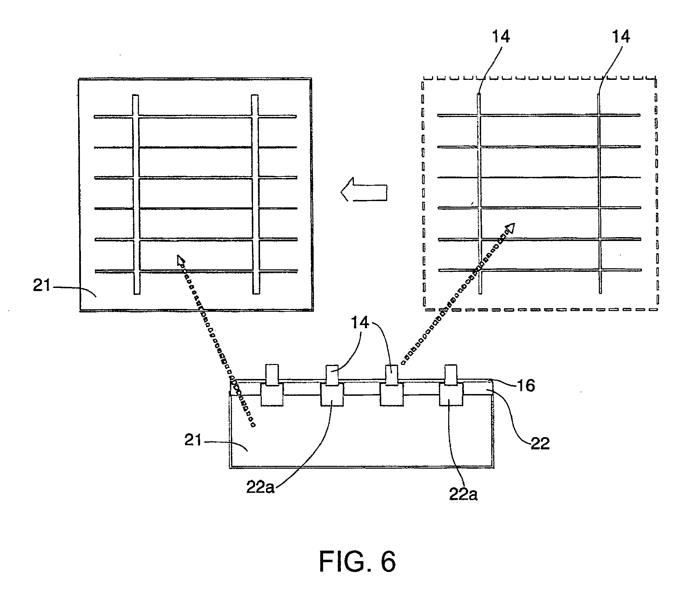

Figure 6 is a schematic view of the alignment of selective emitters for the production of a solar cell;
Figure 7 illustrates a processing sequence used to deposit the conducting layer on a first heavily doped region of a solar cell according to embodiments of the invention;
Figure 8 illustrates examples of images that can be acquired using one or more embodiments of the invention;
Figure 9 illustrates an example of a process that can be used to detect the alignment of a selective emitter according to on embodiment of the invention;
Figure 10 is an example of an image that can be acquired using one or more embodiments of the invention; and
Figure 11 illustrates an example of an image that can be acquired using one or more of the embodiments of the invention disclosed herein.

To facilitate understanding, identical reference numbers have been used, where possible, to designate identical elements that are common to the figures. It is contemplated that elements and features of one embodiment may be beneficially incorporated in other embodiments without further recitation.

### DETAILED DESCRIPTION OF A PREFERENTIAL FORM OF EMBODIMENT

Embodiments of the present invention provide an apparatus and a method for processing substrates in a system that utilizes an improved patterned material deposition processing sequence that can improve the device yield and the cost of ownership (CoO) of a substrate processing line. In one embodiment, the system is a screen printing system that is adapted to perform a screen printing process within a portion of a crystalline silicon solar cell production line in which a substrate is patterned with a desired material and is then processed in one or more subsequent processing chambers. The subsequent processing chambers may be adapted to perform one or more bake steps and one or more cleaning steps. While the discussion herein primarily discusses the processes of screen printing a pattern, such as a contact or interconnect structure on a surface of a solar cell device, this configuration is not intended to be limiting as to the scope of the invention described. Other substrate materials that may benefit from the invention include substrates that may have active regions that contain single crystal silicon, multi-crystalline silicon, polycrystalline silicon or other desirable substrate materials.

### Optical inspection system

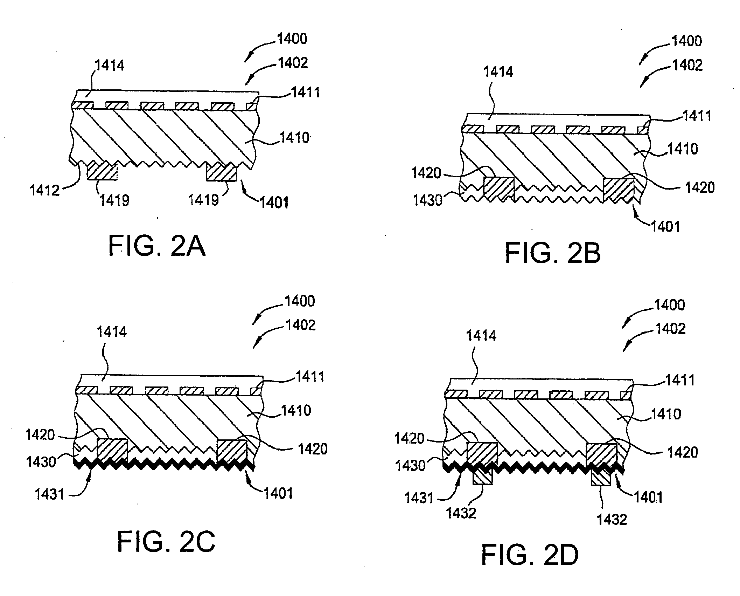

Embodiments of the invention generally provide a solar cell formation process that includes the formation of metal contacts 1432 over first heavily doped regions 1420 that are formed in a desired pattern on a surface of a substrate 1410. In some configurations, the first heavily doped region 1420 defines the selective emitter lines or regions, and is surrounded by a second doped emitter region 1430 (Figs. 2A-2D).

Some embodiments of the invention provide an inspection system and a support apparatus that is used to reliably position a similarly shaped, or patterned, metal contact structure on the patterned heavily doped regions to allow an Ohmic contact to be made with the first heavily doped regions 1420.

Fig. 2D is a side cross-sectional view of a surface 1401 of a substrate 1410 that has the first heavily doped regions 1420, which define the SE lines, and the patterned metal contact structure 1432 formed thereon.

The metal contact structure 1432, such as fingers and busbars, is formed on the first heavily doped regions 1420 so that a high quality electrical connection, (i.e., shime contact) can be formed between these two regions. As noted above, high quality electrical contacts that have a Low-resistance, and are stable contacts are critical for the performance of the solar cell.

It is believed that the ability to detect the actual alignment and orientation of the formed first heavily doped regions 1420 pattern is particularly difficult after both the heavily doped and lightly doped regions are formed in the substrate 1410 and are covered with an antireflection coating layer 1431(i.e., SiN Layers).

Embodiments of the invention thus provide methods of first detecting the actual alignment and orientation of the first patterned heavily doped regions 1420, and then forming patterned metal contacts on the surface of the first heavily doped regions 1420 using the collected information.

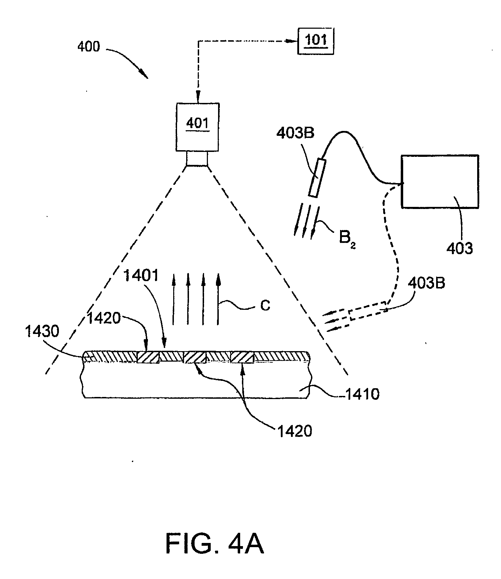

Fig. 4A shows one embodiment of an optical inspection system 400 that is configured for the acquisition of at least an optical image of the front surface 1401 of the substrate 1410, by means of which to determine the actual alignment and orientation of the pattern of the first heavily doped regions 1420 formed on the front surface 1401 of the substrate 1410. For the purposes of the invention, the expression "optical image" means an image acquired in the visible infrared or other desirable wavelengths.

In some embodiments, the optical inspection system 400 generally contains a detector assembly 401, which is configured to acquire the radiation emitted or reflected by the front surface 1401 of the substrate 1410 so that the alignment and orientation of the first heavily doped regions 1420 can be optically determined relative to the other non-heavily doped regions of the substrate 1410.

In some embodiments, the optical inspection system 400 contains a source of electromagnetic radiation, like a radiation source 403, that is configured to emit radiation on a desired wavelength. In some examples, the radiation source 403 may comprise a laser, electron beam, illuminator, a monochromatic light source, infrared (IR) light, light emitting diode (LED), LED array, Hg-Cd lamp, arc lamp, flash lamp, Xe or halogen lamp, or any other suitable source.

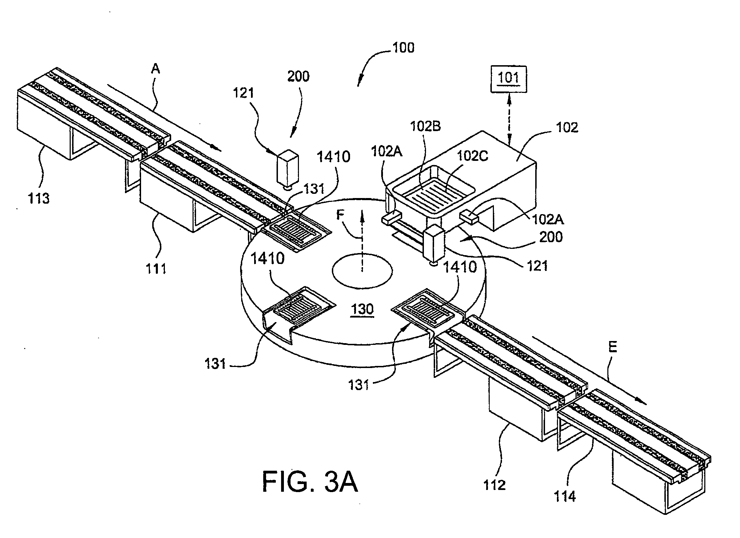

The optical images acquired by the detector assembly 401 and the corresponding data collected regarding alignment and orientation, as will be described hereafter, are then delivered to a system controller 101 that is configured to adjust and control the position of alignment and screen printing of the metal contact structure 1432, such as fingers or busbars, on the surface of the first heavily doped regions 1420 by using a patterned metallization technique. Patterned metallization techniques may include screen printing methods, ink jet printing processes, lithographic processes and the blanket metal deposition process, or other similar patterned metallization techniques. In one embodiment, the metal contacts are disposed on the surface of the substrate 1410 using a screen printing process in a screen printing system 100, as discussed further below with regard to Figs. 3A-3D.

In configurations where the first heavily doped regions 1420 are formed within a silicon substrate, it is believed that electromagnetic radiation emitted at wavelengths within the ultraviolet (UV) and infrared (IR) wavelength regions will either be preferentially absorbed, reflected or transmitted by the silicon substrate or heavily doped regions. The difference in the transmission, absorption or reflection of the emitted radiation can thus be used to create some discernible contrast that can be resolved by the detector assembly 401 and system controller 101. In one embodiment, it is desirable to emit electromagnetic radiations in the wavelength of the visible, i.e., between about 400 nm and 900 nm. In another embodiment, it is desirable to emit optical radiation of the long wave infrared type, with wavelengths greater than or equal to about 8 µm. In one embodiment, the range is between about 8 µm and 14 µm. The optical radiation is emitted until a desired contrast between the regions can be detected by the detector assembly 401, since it is appreciated that a range between 0.9 µm and 1.7 µm, with respect to the short wave infrared spectrum, is highly sensitive to the dopant concentration. Therefore, the range is particularly suitable for the production of selective emitters, and provides a better optical contrast when an optical detection technique of the reflection type is used, as well as representing a lower cost for the detector assembly 401.

In one embodiment, the radiation source 403 is a light emitting diode (LED) able to deliver one or more of the desired light wavelengths. In another embodiment, the radiation source 403 is an illuminator that emits radiation from a halogen bulb transmitted by a bundle of optic fibers 403B.

In another embodiment, the radiation source 403 is absent, or is not used, and the detector assembly 401 is configured to detect electromagnetic radiation in the infrared range that is emitted from a surface of a heated substrate 1410, which is at a temperature greater than ambient temperature.

In one embodiment, the optical inspection system 400 has a radiation source 403 that is configured to transmit an electromagnetic radiation "B2" to a surface 1401 of a substrate 1410, which is on the same side of the substrate as the detector assembly 401. In this configuration, the one or more of the emitted wavelengths will be reflected by portions of the substrate 1410, the first heavily doped regions 1420 and/or the second doped emitter region 1430 and transmitted to the detector assembly 410 following path "C."

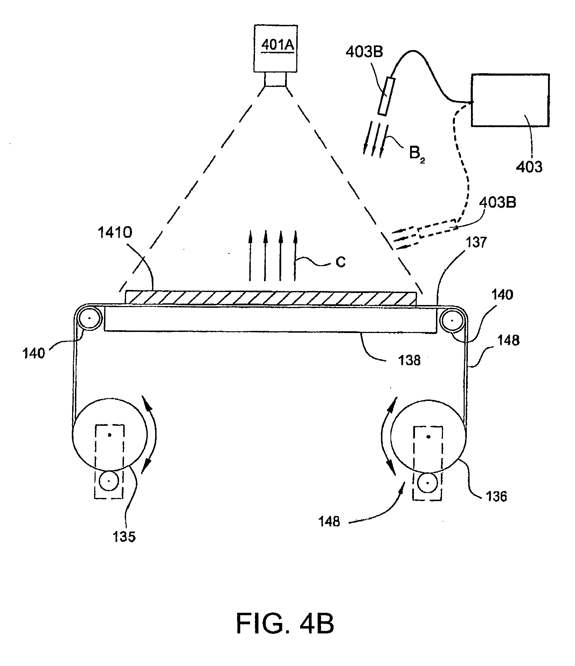

The detector assembly 401 comprises an electromagnetic radiation detector, a camera or other similar device, associated with a lens, that is configured to measure the intensity of the received electromagnetic radiation at one or more wavelengths. In one embodiment, referring to Fig. 4B, the detector assembly 401 comprises a camera 401A that is configured to detect and resolve the distinctive elements on a surface of a substrate within a desired wavelength range emitted by the radiation source 403. In one embodiment, the camera 401A is an InGaAs type camera that has a cooled CCD array to enhance the signal-to-noise ratio of the detect signal. In some configurations, it is desirable to isolate the detector assembly 401 from ambient light by enclosing or shielding the areas between the surface 1401 of the substrate 1410 and the camera 401A.

In one embodiment, the detector assembly 401 also comprises one or more optical filters (not shown), that are disposed between the camera 401A and the surface 1401 of the substrate. In this configuration, the optical filter/filters is/are selected to allow only certain desired wavelengths to pass to the camera 401A to reduce the amount of unwanted energy being received by the camera 401A to increase the signal-to-noise ratio of the detected radiation. The optical filter/filters can be a band-pass filter, a narrow band filter, an optical edge filter, a notch filter or a wide band filter purchased for example from Barr Associates Inc., or Andover Corporation. In another aspect of the invention, an optical filter is added between the radiation source 403 and the substrate 1410 to limit the wavelengths projected onto the substrate and detected by the camera 401A. In this configuration, it may be desirable to select radiation sources 403 that can deliver a broad range of wavelengths and use filters to limit the wavelengths that strike the surface of the substrate.

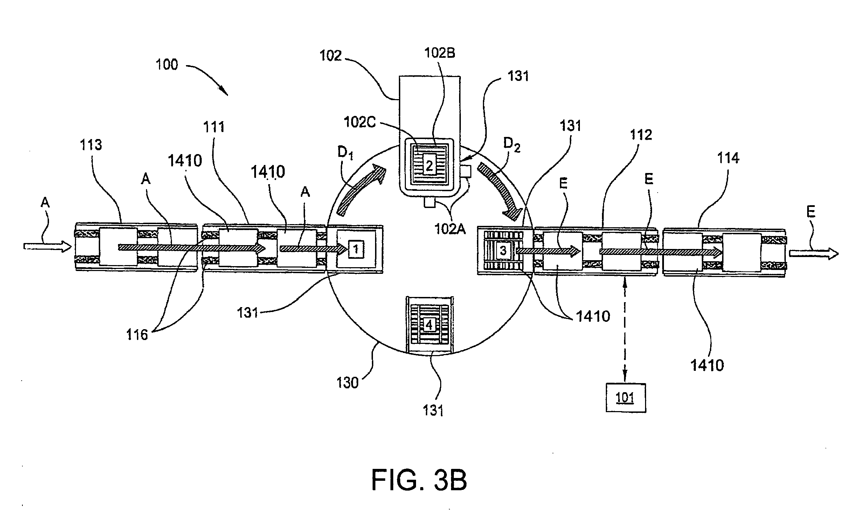

Fig. 3A is a schematic isometric view and Fig. 3B is a schematic plan view that illustrates one embodiment of a screen printing system, or system 100, that may be used in conjunction with embodiments of the present invention to form the metal contacts in a desired pattern on a surface of a solar cell substrate 1410 using the optical inspection system 400. In one embodiment, the system 100 comprises an incoming conveyor 111, a rotary actuator assembly 130, a screen print chamber 102, and an outgoing conveyor 112. The incoming conveyor 111 may be configured to receive a substrate 1410 from an input device (i.e., path "A" in Fig. 3B), such as an input conveyor 113, and to transfer the substrate 1410 to a printing nest 131 coupled to the rotary actuator assembly 130. The outgoing conveyor 112 may be configured to receive a processed substrate 1410 from a printing nest 131 coupled with the rotary actuator assembly 130 and to transfer the substrate 1410 to a substrate removal device, such as an exit conveyor 114 (i.e., path "E" in Fig. 3B). The input conveyor 113 and the exit conveyor 114 may be automated substrate handling devices that are part of a larger production line.

The rotary actuator assembly 130 may be rotated and angularly positioned about the axis "F" by a rotary actuator (not shown) and a system controller 101, so that the printing nests 131 may be selectively angularly positioned within the system 100 (i.e., paths "D1" and "D2" in Fig. 3B). The rotary actuator assembly 130 may also have one or more supporting components to facilitate the control of the printing nests 131 or other automated devices used to perform a substrate processing sequence in the system 100.

In one embodiment, the rotary actuator assembly 130 includes four printing nests 131, or substrate supports, that are each adapted to support a substrate 1410 during the screen printing process performed within the screen print chamber 102. Fig. 3B schematically illustrates the position of the rotary actuator assembly 130 in which one printing nest 131 is in position "1" to receive a substrate 1410 from the incoming conveyor 111, another printing nest 131 is in position "2" within the screen print chamber 102 so that a substrate 1410 can receive a screen printed pattern on a surface thereof, another printing nest 131 is in position "3" for transferring a processed substrate 1410 to the outgoing conveyor 112, and another printing nest 131 is in position "4", which is an intermediate stage between positions "1" and "3".

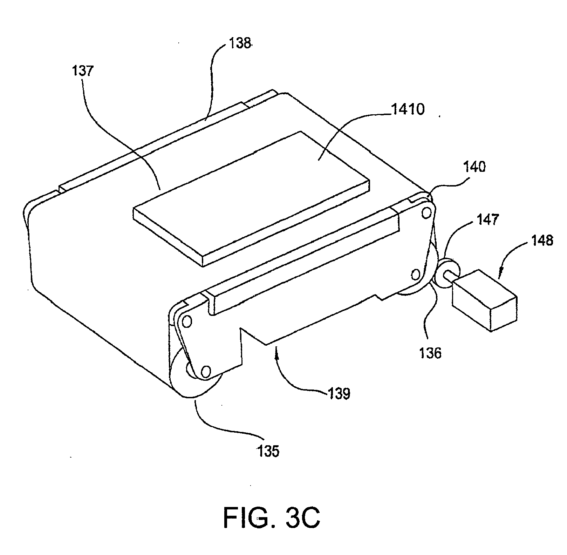

As shown in Fig. 3C, a printing nest 131 generally consists of a conveyor assembly 139 which has a feed spool 135, a take-up spool 136, rollers 140 and one or more actuators 148, which are coupled to the feed spool 135 and/or the take-up spool 136, that are adapted to feed and retain a supporting material 137 positioned across a platen 138. The platen 138 generally has a substrate supporting surface on which the substrate 1410 and the supporting material 137 are positioned during the screen printing process performed in the screen print chamber 102. In one embodiment, the supporting material 137 is a porous material that allows a substrate 1410, which is disposed on one side of the supporting material 137, to be retained on the platen 138 by a vacuum applied to the opposing side of the supporting material 137 by a conventional vacuum generating device (e.g. vacuum pump, vacuum ejector). In one embodiment, a vacuum is applied to vacuum ports (not shown) formed in a substrate supporting surface 138A of the platen 138 so that the substrate can be "chucked" to the substrate support surface 138A of the platen 138. In one embodiment, the supporting material 137 is a transpirable material that consists for instance of a transpirable paper of the type used for cigarettes or other analogous material, such as a plastic or textile material that performs the same function. In one example, the supporting material 137 is a cigarette paper that does not contain benzene lines.

In one configuration, actuators 148 are coupled to, or are adapted to engage with, the feed spool 135 and the take-up spool 136 so that the movement of a substrate 1410 positioned on the supporting material 137 may be accurately controlled within the printing nest 131. In one embodiment, the feed spool 135 and the take-up spool 136 are each adapted to receive opposing ends of a length of the supporting material 137. In one embodiment, the actuators 148 each contain one or more drive wheels 147 that are coupled to or in contact with the surface of the supporting material 137 positioned on the feed spool 135 and/or the take-up spool 136 to control the motion and position of the supporting material 137 across the platen 138.

In one embodiment, referring to Fig. 3A, the system 100 includes an inspection assembly 200 adapted to inspect a substrate 1410 located on the printing nest 131 in position "1". The inspection assembly 200 may include one or more cameras 121 positioned to inspect an incoming, or processed, substrate 1410 located on the printing nest 131 in position "1". In this configuration, the inspection assembly 200 includes at least one camera 121 (e.g., CCD camera) and other electronic components capable of inspecting and communicating the inspection results to a system controller 101 used to analyze the orientation and position of the substrate 1410 on the printing nest 131. In another embodiment, the inspection assembly 200 comprises the optical inspection system 400 discussed above.

The screen print chamber 102 is adapted to deposit material in a desired pattern on the surface of the substrate 1410 positioned on the printing nest 131 in position "2" during the screen printing process. In one embodiment, the screen print chamber 102 includes a plurality of actuators, for example actuators 102A (e.g., stepper motors or servomotors) that are in communication with the system controller 101 and are used to adjust the position and/or angular orientation of the screen printing mask 102B (Fig. 3B) disposed within the screen print chamber 102 with respect to the substrate 1410 being printed. In one embodiment, the screen printing mask 102B is a metal sheet or plate with a plurality of distinctive elements 102C (Fig. 3B). In one embodiment, the distinctive element may include holes, slots or other apertures formed therethrough to define a pattern and placement of screen printed material (i.e., ink or paste) on a surface of the substrate 1410. In general, the screen printed pattern that is to be deposited on the surface of the substrate 1410 is aligned with the substrate 1410 in an automated fashion by orienting the screen printing mask 102B in a desired position on the substrate surface using the actuators 102A and information received by the system controller 101 from the inspection assembly 200. In another embodiment, the screen print chamber 102 is adapted to deposit a material containing metal or dielectric material on a solar cell substrate having a width between about 125 mm and about 156 mm and a length between about 70 mm and about 156 mm. In one embodiment, the screen print chamber 102 is adapted to deposit a paste containing metal on the surface of the substrate to form the metal contact structure on the surface of the substrate.

The system controller 101 facilitates the control and automation of the overall system 100 and may include a central processing assembly (CPU) (not shown), memory (not shown), and support circuits (or I/O) (not shown). The CPU may be one of any form of computer processors that are used in industrial settings for controlling various chamber processes and hardware (e.g., conveyors, optical inspection assemblies, motors, fluid delivery hardware, etc.) and monitor the system and chamber processes (e.g., substrate position, process time, detector signal, etc.). The memory is connected to the CPU, and may be one or more of a readily available memory, such as random access memory (RAM), read only memory (ROM), a floppy disk, hard disk or any other form of digital storage, local or remote. Software instructions and data can be coded and memorized within the memory for instructing the CPU. The support circuits are also connected to the CPU for supporting the processor in a conventional manner. The support circuits may include cache, power supplies, clock circuits, input/output circuitry, sub-systems and the like. A program (or computer instructions) readable by the system controller 101 determines which tasks are performable on a substrate. Preferably, the program is software readable by the system controller 101 which includes code to generate and store at least substrate positional information, the sequence of movement of the various controlled components, substrate optical inspection system information, and any combination thereof. In one embodiment of the invention, the system controller 101 includes pattern recognition software to resolve the positions of the first heavily doped regions 1420 and/or the second doped emitter region 1430 and/or alignment marks or distinctive elements, obtainable as described in the application WO-A-2010/068331.

In an effort to directly determine the alignment and orientation of the first heavily doped regions 1420 and the second doped emitter region 1430 formed on the substrate surface 1401 prior to forming a patterned conducting layer thereon, the system controller 101 may use one or more of the optical inspection systems 400 to collect the desired data.

Fig. 4B shows one embodiment of the optical inspection system 400 that is incorporated into part of the printing nest 131 and optical inspection assembly 200. In one embodiment, the inspection assembly 200 comprises a camera 401A, and the printing nest 131 comprises conveyor assembly 139, supporting material 137, platen 138, and radiation source 403. In this configuration, the radiation source 403 is adapted to emit electromagnetic radiation "B2" to a surface 1401 of a substrate 1410 which is positioned on the supporting material 137 and on the platen 138 so that one or more of the wavelengths emitted will be absorbed or reflected by portions of the substrate 1410 and delivered toward the camera 401A following the path "C."

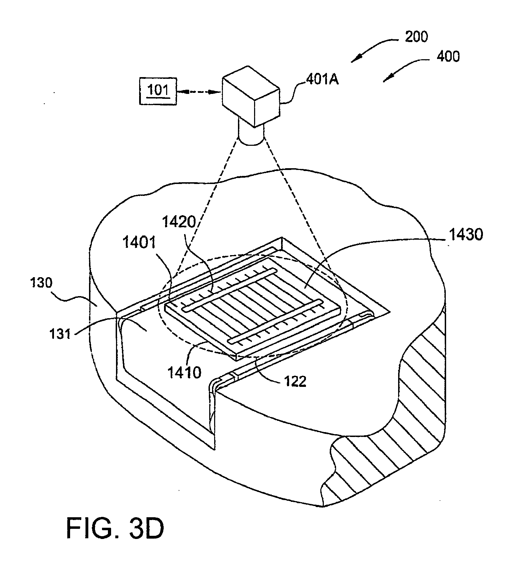

Fig. 3D is a schematic isometric view of one embodiment of the rotary actuator assembly 130 that shows inspection assembly 200 that is positioned to inspect a surface 1401 of a substrate 1410 disposed on a printing nest 131. In one embodiment, the camera 401A is positioned over the surface 1401 of the substrate 1410 so that a viewing area 122 of the camera 401A can inspect at least one region of the surface 1401. The information received by the camera 401A is used to align the screen printing mask, and thus subsequently deposit material, to the first heavily doped regions 1420 by the use of commands sent to the actuators 102A from the system controller 101. During normal process sequencing, of the position of the first heavily doped regions 1420 and/or the second doped emitter region 1430, information is collected for each substrate 1410 positioned on each printing nest 131 before the latter is delivered to the screen print chamber 102. The inspection assembly 200 may also include a plurality of optical inspection systems 400 that are adapted to view different areas of the substrate 1410 positioned on the printing nest 131 to help better resolve the pattern formed on the substrate.

### Method to produce solar cells with selective emitters

Some embodiments of the invention provide a solar cell formation process with selective emitters which comprises making a metal contact structure 1432 (e.g., fingers and busbars) disposed and aligned on first heavily doped regions 1420 that constitute the selective emitters, surrounded by a second doped emitter region 1430 made on the front surface 1401 of the textured substrate 1410. Typical texturing processes provide a surface having a roughness between about 1 micron µm and about 10 µm. The deposition of the metal containing materials used to form the fingers and busbars on the textured surface can greatly affect the electrical resistance of the formed fingers and busbars, due to the increased surface area that the deposited metal must cover, as opposed to an untextured area. Similarly, the roughness of the textured surface will also greatly affect the spatial resolution of the formed heavily doped regions, due to the increase in surface area of these regions through which the dopant atoms will pass during the formation process, as opposed to an untextured surface. Also, as noted above, conventional inspection techniques are typically not able to optically determine the position of the heavily doped regions on a substrate surface. Therefore, it is desirable to reliably position the fingers and busbars on the heavily doped regions to assure full Ohmic contact is created between the heavily doped regions and the fingers and busbars.

### Method for the production of selective emitters

Figs. 2A-2D describe a schematic cross-sectional view of a solar cell substrate 1410 during different stages of a processing sequence used to form active regions of a solar cell device.

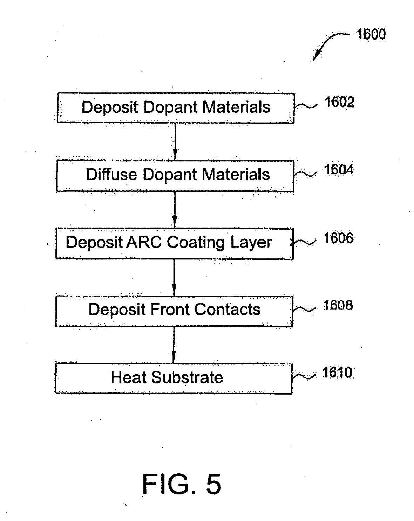

The process sequence 1600 shown in Fig. 5, which corresponds to the stages shown in Figs. 2A-2D, can be used to form a selective emitter structure on the front surface 1401 of the solar cell device, such as a solar cell 1400.

In one embodiment, the solar cell 1400 formed generally contains the substrate 1410, first heavily doped regions 1420 and a contact layer 1414, disposed on a back surface 1402 of the substrate 1410 opposite the front surface 1401.

In one example, the substrate 1410 is p-type doped crystalline substrate.

In one configuration, the contact layer 1414 is disposed over a dielectric layer 1411, such as a silicon dioxide layer, silicon nitride layer or silicon oxynitride layer, of the p-type, and is deposited on the back surface 1402.

In one embodiment, the contact layer 1414 comprises a metal that is between about 2000 angstroms (Å) and about 50,000 A thick. In one embodiment, the contact layer 1414 is a layer of refractory metal or an alloy of refractory metals, such as titanium (Ti), tantalum ((Ta), tungsten (W), mobybdenum (Mo), titanium nitride (TiN), tantalum nitride (TaN), tungsten nitride (WN), and/or mobybdenum nitride (MoN), and the like. The refractory metal or alloy of refractory metals containing the contact layer 1414 is therefore capable of supporting some of the high temperature processing steps in the processing sequence 1600, which will be discussed below. However, the presence of the refractory metal or alloy of refractory metals containing contact layer 1414 is not intended to be limiting as to the scope of the invention, since the contact layer 1414 may be deposited after the high-temperature processes have been performed.

In some embodiments, the front surface 1401 is textured, as indicated by the reference number 1412 in Fig. 2A, in order to improve the light trapping of the formed solar cell 1400.

At step 1602, as shown in Figs. 2A and 5, a first dopant material 1419, formed by first dopant atoms with a first dopant concentration, is deposited on the front surface 1401 of the substrate 1410. In one embodiment, the first dopant material 1419 is deposited or printed in a desired pattern by the use of ink jet printing, or screen printing, rubber stamping or other similar process.

The first dopant material 1419 may initially be a liquid, a paste or gel that is used to form a first heavily doped region having a first dopant concentration, typically about 1020 atoms/cm3.

In some cases, after disposing the first dopant material 1419, the substrate is heated to a desirable temperature to assure that the first dopant material 1419 will remain on the front surface 1401 and cause the first dopant material 1419 to cure, densify and/or form a bond with the front surface 1401.

Typically, n-type dopants used in silicon solar cell manufacturing are elements such as phosphorous (P), arsenic (As) or antimony (Sb). In one embodiment, the first dopant material 1419 is a doping paste containing phosphorous that is deposited on the front surface 1401 of the substrate 1410. The substrate is heated to a temperature of between about 80°C and about 500°C. In another embodiment, the first dopant material 1419 may contain materials selected from a group consisting of polyphosphoric acid, phosphosilicate glass precursors, phosphoric acid (H₃PO₄), phosphorus acid (H3P03), hypophosphorus acid (H₃PO2), and/or various ammonium salts thereof. In one embodiment, the first dopant material 1419 is a gel or paste that contains from about 6 to about 30 atomic % of phosphorus.

The process described in box 1602 may be performed by means of a screen print chamber 102 positioned within the screen printing system 100, as discussed with regard to Figs. 3A-3D.

At step 1604, as shown in Figs. 2B and 5, the substrate 1410 is heated to diffuse the first dopant material 1419. In one embodiment, the substrate 1401 is heated to a temperature greater than about 750°C to cause the doping elements of the first dopant material 1419 to diffuse into the front surface 1401 of the substrate 1410, thereby forming the first heavily doped region 1420 inside the substrate 1410 that constitutes the selective emitters.

Each of the first heavily doped regions 1420 formed can thus be used as a heavily doped region where a good electrical connection can be made on the front surface of the first heavily doped region 1420 of the solar cell 1400.

In one example, it is desirable for the first heavily doped region 1420 to have a sheet resistance of less than about 50 Ohm per square centimeter (Ω/cm2).
In one embodiment of step 1604, the substrate is heated to a temperature between about 750°C and about 1300°C in the presence of nitrogen (N2), oxygen (O2), hydrogen (H2), air or a combination thereof, for a time of between 1 minute and about 120 minutes.

In another embodiment, the substrate is heated in a rapid thermal annealing chamber (RTA) in a nitrogen-rich (N2) environment to a temperature of about 1000°C for about 5 minutes.

In yet another embodiment of step 1604, the regions of the front surface 1401 of the substrate 1410 between the deposited first dopant material 1419 are doped with a second dopant material formed by second dopant atoms with a second dopant concentration. The second dopant concentration is lower than that of the first dopant concentration. For example the second dopant may be an n-type dopant so as to form a second doped emitter region 1430.

In some embodiments, the first dopant atoms of the first dopant material 1419 and the second dopant atoms of the second dopant material are the same type.

In one embodiment, during a part of the process of driving in the first dopant material 1419 into the front surface 1401 of the substrate, the front surface is exposed to a dopant containing vapor or gas, to form the second doped emitter region 1430.

In one embodiment, at least a portion of the dopant containing vapor is created by the vaporization of some of the first dopant material 1419 during the thermal processing.

In another embodiment, the front surface 1401 is exposed to acid during thermal processing so as to form the second doped emitter region 1430 in an n-type solar cell substrate.

In yet another embodiment, the front surface 1401 of the substrate is exposed to POCl3, or another desirable dopant containing gas, while the substrate is thermally processed in a tube furnace.

Although not shown here, a person of skill will certainly appreciate that the contact layer 1414 advantageously forms a reliable protection mask which prevents an undesired doping of the rear surface 1402 by the dopant containing vapors that is used to form, or is a by-product of forming, the first heavily doped regions 1420 and the second doped emitter region 1430.

In one embodiment, the formed second doped emitter region 1430 to has a sheet resistance between about 80 and 200 Ohms per square centimeter (Ω/cm2).

The drive-in process of the second dopant material described at step 1604 may be performed by the heat treatment module, or second processing module, connected to the system 100.

At step 1606, as shown in Figs. 2C and 5, an antireflection (ARC) layer 1431 is formed on the front surface 1401 of the substrate.

In one embodiment, the antireflection layer 1431 comprises a thin passivation/antireflection layer (e.g., silicon nitride, silicon oxide). While Fig. 2C shows an antireflection layer 1431 that is a single layer, this configuration is not intended to be limiting as to the scope of the invention, and is only intended to illustrate one example of an antireflection layer. In one example, the passivation/antireflection layer comprises two or more layers that comprise silicon nitride or silicon oxides. The deposition of the antireflection layer described at step 1606 may be performed by a fourth processing module positioned in the system 100.

In one embodiment, the antireflection layer is deposited using a PVD chamber or a CVD chamber.

In one embodiment, the antireflection layer formation process may be performed using a third processing module, for example a plasma-enhanced CVD deposition module that is attached to the system 100.

At step 1608, as shown in Figs. 2D and 5, a patterned conducting layer 1432 is deposited on the antireflection layer 1431. In one embodiment, the formed conducting layer 1432 has a thickness between about 2000 Å and about 50,000 angstroms A and contains a metal.

In one embodiment, the formed conducting layer 1432 is made with a paste containing metal, such as a paste containing silver (Ag), which is screen printed on the front surface 1401 of the substrate.

In one embodiment, a desired pattern of the conducting layer 1432 is deposited over the first heavily doped regions 1420, so that the conducting layer 1432 will form a good electrical contact with the first heavily doped regions 1420 after a subsequent thermal process has been carried out at step 1610.

In one embodiment, portions of the antireflection layer 1431 disposed over the first heavily doped regions 1420 are removed prior to depositing the conducting layer 1432 on the first heavily doped regions 1420.

In general, the processes of aligning and positioning the conducting layer 1432 with the first heavily doped regions 1420 provides an alignment that exploits the determination of the actual position of parts of the front surface 1401 with respect to distinctive elements present on the front surface 1401 of the substrate.

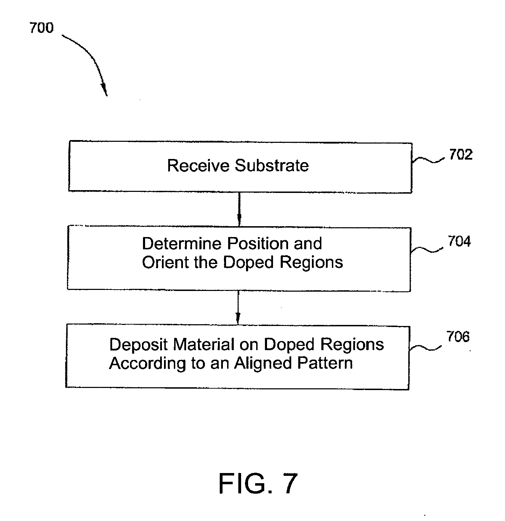

In one embodiment of step 1608, as shown in Fig. 7, the conducting layer 1432 is screen printed on the first heavily doped regions 1420 using the system 100 and the processing steps found in the processing sequence 700. The process sequence 700 starts with step 702, in which a printing nest 131 that is in position "1" receives a substrate 1410 from the incoming conveyor 111 and "chucks" the substrate on the platen 138.

Next, at step 704, the system controller 101 and an optical inspection system 400, which is configured similar to the one shown in Fig. 4B, are used to detect the pattern of the first heavily doped regions 1420 and/or the second doped emitter region 1430 using the electromagnetic radiation detected, as shown more clearly hereafter in the description.

Next, at step 706, the rotary actuator assembly 130 rotates the printing nest 131 to the screen print chamber 102 (i.e., path D1). In step 706, the system controller 101 and the actuators 102A then orient and align the screen printing mask, which has a desired screen printing pattern formed therein, to the first heavily doped regions 1420 formed on the substrate 1410, using the data received during step 704. Once the screen printing mask is aligned, the conducting layer 1432 is disposed on the first heavily doped regions 1420 by delivering the conducting layer of paste or gel through the distinctive signs formed in the screen printing mask 102B.

Subsequently, the processed substrate 1410 is then transferred to the outgoing conveyor 112 (i.e., path D2) so that it may be transferred to other subsequent processing chambers.

In an alternative embodiment of step 704, the optical inspection assembly 200 and the system controller 101 are configured to determine the position and orientation of the first heavily doped regions 1420 formed on the surface 1401 of the substrate 1410, due to the contrast created between the first heavily doped regions 1420 and the second doped emitter region 1430. In this configuration, the optical inspection assembly 200 includes a camera or other similar device that is able to detect the formed pattern due to the variation in the dopant concentration using ambient light or light from an incandescent lamp or other lamp or infrared light, from a lamp or emitted by the substrate itself.

In one embodiment, the viewing area of the optical inspection assembly 200 is positioned so that it can see and resolve the first heavily doped regions 1420 and the second doped emitter region 1430 found on the surface 1401. Next, using the information received from the optical inspection assembly 200, the system controller 101 then controls the deposition of the conducting layer 1432 on the first heavily doped regions 1420 following the steps described above.

In one embodiment, the conducting layer 1432 is a material containing silver which is deposited in a desired pattern by use of a screen printing process, ink jet printing or other similar process in a fourth processing module coupled to the system 100.

The deposition of the conducting layer 1432 described at step 1608 may be performed by a fourth processing module that is positioned in the system 100. The fourth processing module may include, but is not limited to, chemical vapor deposition (CVD) chambers, sputtering chambers, physical vapor deposition (PVD) chambers, plasma-enhanced chemical vapor deposition (PECVD) chambers.

At step 1610, the substrate is heated. In one embodiment, the substrate is heated to a temperature greater than 400°C and/or less than about 800°C to densify and/or diffuse the conducting layer 1432 into the front surface 1401 of the substrate 1410 to form a desirable Ohmic contact with the portions of the first heavily doped regions 1420.

In one embodiment of step 1610, the substrate is heated to a temperature between about 400°C and about 500°C in the presence of nitrogen (N2), oxygen (O2), hydrogen (H2), air or combinations thereof, for a time of between about 1 minute and about 120 minutes.

In one embodiment, the substrate is heated in a fifth processing module which is positioned in the system 100.

Alternatively, the heat treatment module may be used to heat the substrate, which is positioned in the system 100. An annealing chamber can, a tubular furnace chamber, a belt furnace, or any other suitable heating method may be used.

The embodiments described here are advantageous over other conventional techniques, in that the electrical connections formed between the conducting layers 1432 will have a low contact resistance and will not damage the formed solar cell junctions by "spiking" through the emitter formed on the underlying p-type material.

In the configurations described here, the conducting layers 1432 are fired through the antireflection layer and/or the dielectric layer, using a firing furnace module positioned in the system 100. In one example, the firing furnace module is a furnace configured to heat the substrate to a desired temperature to form a desired contact with the patterned metal layers formed on the substrate surfaces.

### Data acquisition for alignment of selective emitters

In a first embodiment, the acquisition of the pattern of the first heavily doped regions 1420 at step 704 provides operation in the field of visible light, adopting an optical filter, and using the optical inspection system 400 and a technique of processing the images acquired by the system 400, based on Fourier transform, while using the control system 101.

The first embodiment uses the optical inspection system 400, in which the electromagnetic radiation emitted by the radiation source 403 and received by the detector assembly 401, for example by the camera 401A (Fig. 4B), is in the visible wavelength of between about 400 nm and about 900 nm. It has been found that this first embodiment works well in the case of strong contrasts between the SE lines defined by the first heavily doped regions 1420 and the substrate, particularly in the second doped emitter region 1430, due to differences in the texture or steps of different heights. However, if there is a weak natural contrast, i.e., when there are no differences in texture or steps of different heights but only differences in concentration, as is often the case of SE lines defined by the first heavily doped regions 1420, the invention proposes to combine an optical filtering operation with an image processing with Fourier transform, in order to improve the contrast. In some embodiments, the filtering operation provides the use of a filter to limit the illuminating light to a restricted visible spectrum band, instead of the whole visible spectrum. In fact, the substrate 1410 can advantageously provide a good contrast in a restricted spectrum range which instead could be negatively influenced by a low contrast response in other parts of the spectrum if the whole visible range were used. In other embodiments, the filtering operation could be performed in a restricted spectrum of the infrared field.

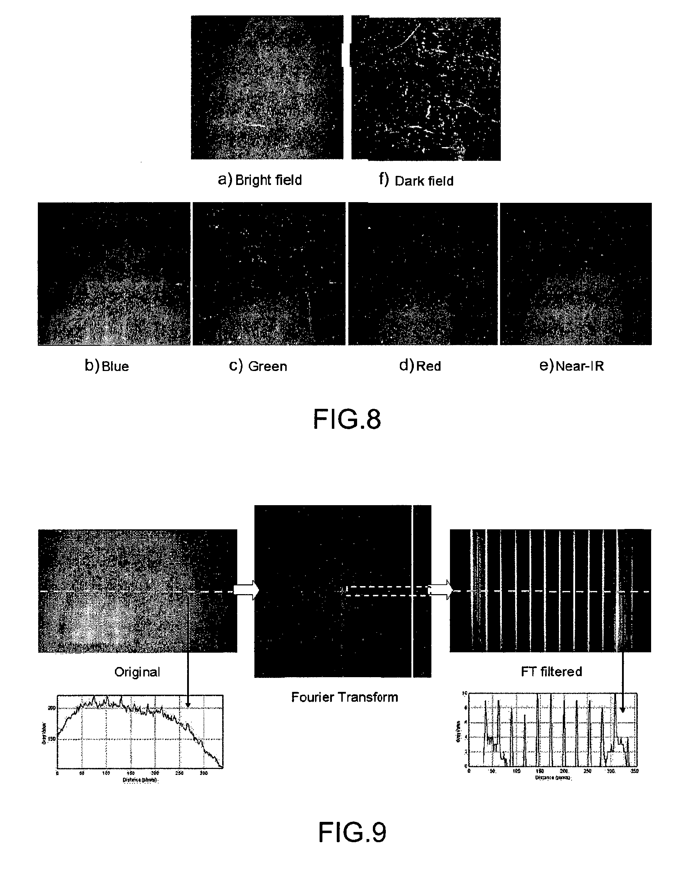

Fig. 8 shows examples of the above described optical filtering. In one embodiment, image a) is the image acquired by the detector assembly 401 in a clear field obtainable using the whole spectrum of the visible, which is compared with the blue, green, red and nearby infrared field, as in the corresponding images b), c), d) and e) acquired by the detector assembly 401. Image e) represents the dark field, obtainable by positioning the optic fiber 403B in the position shown by the phantom lines in Figs. 4A and 4B. In this case, the blue filter (image b) provides the best contrast. In any case, the contrast may be weak, with a low ratio between signal and noise, which makes it difficult to accurately detect the position of the SE lines defined by the first heavily doped regions 1420.

In order to further improve the contrast between the SE lines defined by the first heavily doped regions 1420 and the second doped emitter region 1430, the invention proposes to use Fourier transform (FT) processing of the image acquired by the detector assembly 401 and subject the image to optical filtering.

In one embodiment the Fourier transform processing involves: (i) Fourier transforming the optically filtered image, (ii) selecting and highlighting features of the image in the Fourier transform space of the first heavily doped region 1420, corresponding to SE lines, and busbars, and thereby filtering out unwanted background image to obtain a filtered Fourier transform image; and (iii) inverse Fourier transforming the filtered Fourier transform image to create the final image with a higher contrast between the first heavily doped region 1420 and the second doped emitter region 1430.

The repetitive pattern of the SE lines defined by the first heavily doped regions 1420 of the original image acquired by the detector assembly 401 is advantageous, because it creates strong signals in the Fourier transform space in known positions. This can be highlighted for the inverse Fourier transform, excluding other regions which are not in relation with the SE lines. Furthermore, the Fourier transform processing improves and highlights the repetitive structures present on the substrate 1410. The resulting inverse Fourier transform image shows a much stronger contrast of the SE lines (Fig. 9). If the original image acquired by the detector assembly 401 does not have enough information to produce a strong signal for a given axis, the Fourier transform processing can be used to determine the angular orientation of the substrate with respect to the other axis. This orientation information can be used to generate a detection filter of the edge that improves every distinctive element for the image with a few distinctive elements (for example the axis of the busbars).

As shown above, once a strong contrast is determined in the image acquired by the detector assembly 401, the position of the SE lines can be identified using a standard pattern recognition algorithm. The data thus obtained is used by the controller 101 in the step 706 described above.

In a second embodiment, an image acquisition technique in the long wave infrared is used to detect the different dopant concentration between the SE lines defined by the first heavily doped regions 1420 and the surrounding second doped emitter region 1430. This solution provides the ideal contrast mechanism for the particular application of alignment to the SE lines defined by the first heavily doped regions 1420, irrespective of process or substrate variations. In the second embodiment, the long wave infrared (LWIR) longer than, or equal to, about 8 µm. In some embodiments the long wave infrared (LWIR) used is between about 8 µm and 14 µm.

The second embodiment according to the invention can be actuated in two variants.

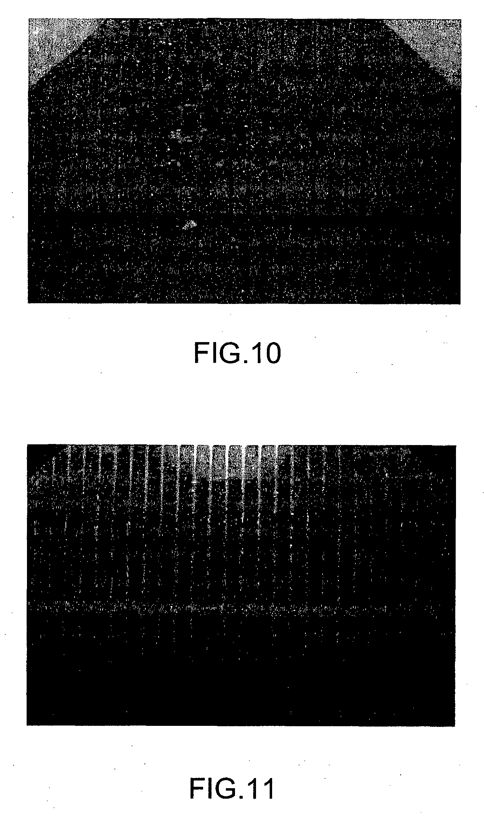

A first variant of the second embodiment provides controlling the substrate 1410 optically with the detector assembly 401 while it is at a temperature above ambient temperature, even by only a few degrees Celsius (°C) (Fig. 10). In one embodiment, the range of wavelengths is longer than, or equal to, about 8 µm. In another embodiment the range is between about 8 µm and 14 µm. In the above described ranges, it is possible, unlike in the detection in the visible or short waves of infrared, to use the contrast mechanism represented by the difference in heat emissivity between the SE lines defined by the first heavily doped regions 1420 and the substrate, in particular the second doped emitter region 1430, since at a given temperature the two regions emit different quantities of infrared light. The first variant has the advantage that it does not require any illumination by means of the radiation source 403, which therefore may be omitted or unused.

A second variant is similar to the standard image acquisition model, which uses the radiation source 403 to illuminate the substrate 1410, wherein the image is formed by the light reflected by the substrate (Fig. 11). As seen in Fig. 11, the contrast between the SE lines defined by the first heavily doped regions 1420 and the substrate, particularly in the second doped emitter region 1430, is seen in the inverse with respect to Fig. 10. In this second variant, the contrast mechanism is given by the difference in reflectivity between the two regions at the IR wavelength longer than, or equal to, about 8 µm. In some embodiments, the range is between about 8 µm and 14 µm. As in the case of image acquisition in the visible wavelength range according to the first embodiment, the position of the SE lines defined by the first heavily doped regions 1420 can be identified using a standard pattern recognition algorithm. The data thus obtained is used by the controller 101 in the step 706 as described above.

## Claims

1. A method for forming solar cells with selective emitters (1420), comprising:
positioning a substrate (1410), on a substrate receiving surface, wherein the substrate has a surface that comprises:
at least a first patterned heavily doped region (1420) formed on said surface, having a first dopant concentration that defines the selective emitters, and
a second doped emitter region (1430) having a second dopant concentration less than the first dopant concentration, wherein the second doped emitter region surrounds the first patterned heavily doped region;
determining a position of the first patterned heavily doped region on the substrate, wherein determining the position comprises:
acquiring an optical image of a portion of the surface,
optical filtering of the optical image,
using a Fourier transform to process the filtered optical image, and
evaluating a contrast between the first patterned heavily doped region and the second doped emitter region in the filtered and the Fourier transformed optical image to determine the position of the first patterned and heavily doped region;
aligning one or more distinctive elements (102C) n a screen printing mask (102B) with the first patterned heavily doped region by using information received from the determined position of the first patterned heavily doped region on the substrate; and
depositing a layer of material (1432) on at least a portion of the first patterned heavily doped region.

2. The method of claim 1, wherein using the Fourier transform to process the filtered optical image comprises:
creating a filtered Fourier transform image by selecting features of the first heavily doped region of the filtered optical image in a Fourier transform space and filtering out unwanted background images; and
transforming the filtered Fourier transform image to create a final image having a higher contrast between the first heavily doped region and the second doped emitter region by use of an inverse Fourier transform.

3. The method of claims 1 or 2, wherein acquiring the optical image of the portion of the surface comprises:
receiving electromagnetic radiation from the surface at a first wavelength, wherein the first wavelength is a restricted sub-range of a visible range or an infrared range.

4. A method for forming solar cells with selective emitters (1420), comprising:
positioning a substrate (1410) on a substrate receiving surface, wherein the substrate has a surface that comprises:
at least a first patterned heavily doped region (1420) formed on the surface, having a first dopant concentration that defines the selective emitters, and
a second doped emitter region (1430) having a second dopant concentration that is less than the first dopant concentration, wherein the second doped emitter region surrounds the first patterned heavily doped region;
determining a position of the first patterned heavily doped region on the substrate, wherein determining the position comprises:
acquiring an optical image of a portion of the surface, wherein acquiring the optical image includes receiving electromagnetic radiation from the surface at a first wavelength in a long wave infrared spectrum longer than, or equal to, about 8 µm;
evaluating a contrast in the optical image between the first patterned heavily doped region and the second doped emitter region;
aligning one or more distinctive elements (102C) in a screen printing mask with the first patterned heavily doped region by using information received from the determined position of the first patterned heavily doped region on the substrate; and
depositing a layer of material (1432) on at least a portion of the first patterned heavily doped region.

5. The method of claims 1-4, wherein the surface is formed by a method comprising:
depositing a first dopant material (141a) having first dopant atoms with the first dopant concentration in a pattern on the surface of the substrate;
heating the substrate and the first dopant material to diffuse the dopant atoms of the first dopant material into the surface, and to form the first patterned heavily doped region; and
depositing a second dopant material having second dopant atoms with the second dopant concentration in the regions surrounding the first patterned heavily doped region to define the second doped emitter region.

6. The method of claim 5, wherein the first dopant atoms and the second dopant atoms are each selected from a group of elements comprising:
phosphorous, arsenic, antimony, boron, aluminum and gallium.

7. The method of claims 5 or 6, wherein the first dopant atoms and the second dopant atoms are the same type of dopant atoms.

8. The method of claims 1-7, wherein the layer deposited on the portion of the first heavily doped region comprises a conductive material, the substrate comprises silicon, and the first dopant concentration is greater than about 10¹⁸ atoms/cm³_{.}

9. The method of claims 1-8, wherein receiving the electromagnetic radiation is obtained by means of an optical detector, located adjacent to the surface.

10. The method of claims 1-9, wherein acquiring the optical image of the portion of the surface comprises:
providing electromagnetic radiation configured to emit radiation towards the surface.

11. The method of claim 10, wherein acquiring the optical image of the portion of the surface further comprises:
detecting a difference in an intensity of the electromagnetic radiation reflected by the portion of the first patterned heavily doped region and the second doped emitter region.

12. The method of claim 9, wherein receiving electromagnetic radiation from the surface of the substrate includes detecting infrared radiation emitted by the substrate at a temperature higher than ambient temperature.

13. An apparatus for forming solar cells with selective emitters, comprising:
a support surface (138A) configured to support a substrate (1410);
a detector assembly (401) configured to acquire an optical image of a portion of a surface of the substrate, and configured to filter the optical image;
a deposition chamber having a screen printing mask and at least an actuator configured to position the screen printing mask; and
a controller (101) configured to:
receive the filtered optical image,
Fourier transform the filtered optical image,
evaluate a contrast between the first heavily doped region and the second doped emitter region of the filtered optical image and the Fourier transformed optical image, and
align a position of the screen printing mask (102B) relative to a first patterned heavily doped region (1420) of the substrate according to the evaluation.

14. An apparatus for forming solar cells with selective emitters, comprising:
a support surface (138A) configured to support a substrate (1410):
a detector assembly (401) configured to acquire an optical image of a portion of a surface of the substrate by receiving electromagnetic radiation from the surface, at a first wavelength in the long wave infrared spectrum greater than, or equal to, about 8 µm;
a deposition chamber having a screen printing mask and at least an actuator configured to position the screen printing mask; and
a controller (101) configured to:
receive the optical image from the detector assembly,
evaluate a contrast in the optical image between the first heavily doped region and the second doped emitter region, and
align a position of the screen printing mask (102B) relative to a first patterned heavily doped region (1420) of the substrate according to the evaluation.

15. The apparatus in claims 13 or 14, further comprising:
an electromagnetic radiation source configured to emit electromagnetic radiation towards the surface of the substrate.

16. The apparatus as in claim 13, 14 or 15, wherein the detector assembly comprises at least an optical filter disposed between the surface and a camera, wherein the optical filter is configured to allow the first wavelength to pass therethrough.

## Patentansprüche

1. Verfahren zur Bildung von Solarzellen mit selektiven Emittern (1420), umfassend:
Positionieren eines Substrats (1410) auf einer Substrataufnahmefläche, wobei das Substrat eine Fläche aufweist, die umfasst:
mindestens einen auf der Fläche ausgebildeten ersten strukturierten stark dotierten Bereich (1420), der eine erste Dotierungskonzentration aufweist, die die selektiven Emitter definiert, und
einen zweiten dotierten Emitterbereich (1430), der eine zweite Dotierungskonzentration kleiner als die erste Dotierungskonzentration aufweist, wobei der zweite dotierte Emitterbereich den ersten strukturierten stark dotierten Bereich umgibt;
Bestimmen einer Position des ersten strukturierten stark dotierten Bereichs auf dem Substrat, wobei das Bestimmen der Position umfasst:
Erfassen eines optischen Bildes eines Abschnitts der Fläche, optisches Filtern des optischen Bildes,
Verwenden einer Fourier-Transformation zur Verarbeitung des gefilterten optischen Bildes und
Auswerten eines Kontrasts zwischen dem ersten strukturierten stark dotierten Bereich und dem zweiten dotierten Emitterbereich in dem gefilterten und dem Fourier-transformierten optischen Bild, um die Position des ersten strukturierten stark dotierten Bereichs zu bestimmen;
Ausrichten eines oder mehrerer charakteristischer Elemente (102C) auf einer Siebdruckmaske (102B) an dem ersten strukturierten stark dotierten Bereich unter Verwendung von aus der bestimmten Position des ersten strukturierten stark dotierten Bereichs auf dem Substrat gewonnenen Informationen; und
Aufbringen einer Materialschicht (1432) auf mindestens einem Abschnitt des ersten strukturierten stark dotierten Bereichs.

2. Verfahren nach Anspruch 1, wobei das Verwenden der Fourier-Transformation zur Verarbeitung des gefilterten optischen Bildes umfasst:
Erzeugen eines gefilterten Fourier-Transformationsbildes, indem Merkmale des ersten stark dotierten Bereichs des gefilterten optischen Bildes in einem Fourier-Transformationsraum ausgewählt werden und unerwünschte Hintergrundbilder herausgefiltert werden; und
Transformieren des gefilterten Fourier-Transformationsbildes, um ein finales Bild mit einem höheren Kontrast zwischen dem ersten stark dotierten Bereich und dem zweiten dotierten Emitterbereich durch Verwendung einer inversen Fourier-Transformation zu erzeugen.

3. Verfahren nach einem der Ansprüche 1 oder 2, wobei das Erfassen des optischen Bildes des Abschnitts der Fläche umfasst:
Empfangen elektromagnetischer Strahlung von der Fläche mit einer ersten Wellenlänge, wobei die erste Wellenlänge ein eingeschränkter Teilbereich eines sichtbaren Bereichs oder Infrarotbereichs ist.

4. Verfahren zur Bildung von Solarzellen mit selektiven Emittern (1420), umfassend:
Positionieren eines Substrats (1410) auf einer Substrataufnahmefläche, wobei das Substrat eine Fläche aufweist, die umfasst:
mindestens einen auf der Fläche ausgebildeten ersten strukturierten stark dotierten Bereich (1420), der eine erste Dotierungskonzentration aufweist, die die selektiven Emitter definiert, und
einen zweiten dotierten Emitterbereich (1430), der eine zweite Dotierungskonzentration, die kleiner als die erste Dotierungskonzentration ist, aufweist, wobei der zweite dotierte Emitterbereich den ersten strukturierten stark dotierten Bereich umgibt;
Bestimmen einer Position des ersten strukturierten stark dotierten Bereichs auf dem Substrat, wobei das Bestimmen der Position umfasst:
Erfassen eines optischen Bildes eines Abschnitts der Fläche, wobei das Erfassen des optischen Bildes das Empfangen elektromagnetischer Strahlung von der Fläche mit einer ersten Wellenlänge in einem langwelligen Infrarotspektrum größer als oder gleich etwa 8 11m umfasst;
Auswertung eines Kontrasts in dem optischen Bild zwischen dem ersten strukturierten stark dotierten Bereich und dem zweiten dotierten Emitterbereich;
Ausrichten eines oder mehrerer charakteristischer Elemente (102C) auf einer Siebdruckmaske an dem ersten strukturierten stark dotierten Bereich unter Verwendung von aus der bestimmten Position des ersten strukturierten stark dotierten Bereichs auf dem Substrat gewonnenen Informationen; und
Aufbringen einer Materialschicht (1432) auf mindestens einem Abschnitt des ersten strukturierten stark dotierten Bereichs .

5. Verfahren nach einem der Ansprüche 1-4, wobei die Fläche gebildet wird durch ein Verfahren, umfassend:
Aufbringen eines ersten Dotierungsmaterial (1419) mit ersten Dotierungsatomen mit der ersten Dotierungskonzentration in einer Struktur auf der Fläche des Substrats;
Erhitzen des Substrats und des ersten Dotierungsmaterials, um die Dotierungsatome des ersten Dotierungsmaterials in die Fläche diffundieren zu lassen und um den ersten strukturierten stark dotierten Bereich zu bilden; und
Aufbringen eines zweiten Dotierungsmaterials mit zweiten Dotierungsatomen mit der zweiten Dotierungskonzentration in den den ersten strukturierten stark dotierten Bereich umgebenden Bereichen, um den zweiten dotierten Emitterbereich zu definieren.

6. Verfahren nach Anspruch 5, wobei die ersten Dotierungsatome und die zweiten Dotierungsatome jeweils ausgewählt sind aus einer Gruppe von Elementen, umfassend:
Phosphor, Arsen , Antimon, Bor, Aluminium und Gallium.

7. Verfahren nach einem der Ansprüche 5 oder 6, wobei die ersten Dotierungsatome und die zweiten Dotierungsatome vom gleichen Typ Dotierungsatome sind.

8. Verfahren nach einem der Ansprüche 1-7, wobei die auf dem Abschnitt des ersten stark dotierten Bereichs aufgebrachte Schicht ein leitfähiges Material umfasst, wobei das Substrat Silizium umfasst und die erste Dotierungskonzentration größer als etwa 10^{1g} Atome/cm³ ist.

9. Verfahren nach einem der Ansprüche 1-8, wobei das Empfangen der elektromagnetischen Strahlung mittels eines optischen Detektors, der sich benachbart zu der Fläche befindet, erreicht wird.

10. Verfahren nach einem der Ansprüche 1-9, wobei das Erfassen des optischen Bildes des Abschnitts der Fläche umfasst:
Bereitstellen von elektromagnetischer Strahlung, die zum Emittieren von Strahlung in Richtung der Fläche konfiguriert ist.

11. Verfahren nach Anspruch 10, wobei das Erfassen des optischen Bildes des Abschnitts der Fläche ferner umfasst:
Ermitteln einer Differenz in einer Intensität der elektromagnetischen Strahlung, die durch den Abschnitt des ersten strukturierten stark dotierten Bereichs und den zweiten dotierten Emitterbereich reflektiert wird.

12. Verfahren nach Anspruch 9, wobei das Empfangen elektromagnetischer Strahlung von der Fläche des Substrats das Erfassen von Infrarotstrahlung, die von dem Substrat bei einer Temperatur höher als die Umgebungstemperatur ausgestrahlt wird, umfasst.

13. Vorrichtung zur Bildung von Solarzellen mit selektiven Emittern, umfassend:
eine Tragfläche (138A), die zum Tragen des Substrats (1410) konfiguriert ist;
eine Detektoranordnung (401), die konfiguriert ist, ein optisches Bild eines Abschnitts der Fläche des Substrats zu erfassen und konfiguriert ist, das optische Bild zu filtern;
eine Abscheidungskammer mit einer Siebdruckmaske und mindestens einem Aktuator, der konfiguriert ist, die Siebdruckmaske zu positionieren; und
einen Regler (101), der konfiguriert ist:
das gefilterte optische Bild zu empfangen,
das gefilterte optische Bild einer Fourier-Transformation zu unterziehen,
einen Kontrast zwischen dem ersten stark dotierten Bereich und dem zweiten dotierten Emitterbereich des gefilterten optischen Bildes und des Fouriertransformatierten optischen Bildes auszuwerten und
eine Position der Siebdruckmaske (102B) relativ zu einem ersten strukturierten stark dotierten Bereich (1420) des Substrats gemäß der Auswertung auszurichten.

14. Vorrichtung zur Bildung von Solarzellen mit selektiven Emittern, umfassend:
eine Tragfläche (138A), die zum Tragen des Substrats (1410) konfiguriert ist;
eine Detektoranordnung (401), die konfiguriert ist, ein optisches Bild eines Abschnitts der Fläche des Substrats zu erfassen, indem elektromagnetische Strahlung von der Fläche bei einer ersten Wellenlänge im langwelligen Infrarotbereich größer als oder gleich etwa 8 µm empfangen wird;
eine Abscheidungskammer mit einer Siebdruckmaske und mindestens einem Aktuator, der konfiguriert ist, die Siebdruckmaske zu positionieren; und
einen Regler (101), der konfiguriert ist:
das optische Bild von der Detektoranordnung zu empfangen,
einen Kontrast in dem optischen Bild zwischen dem ersten stark dotierten Bereich und dem zweiten dotierten Emitterbereich auszuwerten und
eine Position der Siebdruckmaske (102B) relativ zu einem ersten strukturierten stark dotierten Bereich (1420) des Substrats gemäß der Auswertung auszurichten.

15. Vorrichtung nach einem der Ansprüche 13 oder 14, ferner umfassend:
eine elektromagnetische Strahlungsquelle, die konfiguriert ist, elektromagnetische Strahlung in Richtung der Fläche des Substrats zu emittieren.

16. Vorrichtung nach einem der Ansprüche 13, 14 oder 15, wobei die Detektoranordnung mindestens einen optischen Filter umfasst, der zwischen der Fläche und einer Kamera angeordnet ist, wobei der optische Filter konfiguriert ist, die erste Wellenlänge durch diesen durch zu lassen.

## Revendications

1. Procédé de formation de cellules solaires à émetteurs sélectifs (1420), comprenant :
le positionnement d'un substrat (1410) sur une surface de réception de substrat, le substrat ayant une surface qui comprend :
au moins une première région (1420) fortement dopée à motif formée sur ladite surface, ayant une première concentration en dopant qui définit les émetteurs sélectifs, et
une deuxième région (1430) d'émetteurs dopée ayant une deuxième concentration en dopant inférieure à la première concentration en dopant, la deuxième région d'émetteurs dopée entourant la première région fortement dopée à motif ;
la détermination d'une position de la première région fortement dopée à motif sur le substrat, la détermination de la position comprenant :
l'acquisition d'une image optique d'une partie de la surface,
le filtrage optique de l'image optique,
l'utilisation d'une transformée de Fourier pour traiter l'image optique filtrée, et
l'évaluation d'un contraste entre la première région fortement dopée à motif et la deuxième région d'émetteurs dopée dans l'image optique filtrée et transformée par transformée de Fourier pour déterminer la position de la première région à motif et fortement dopée ;
l'alignement d'un ou de plusieurs éléments distinctifs (1 02C) dans un masque de sérigraphie (102B) avec la première région fortement dopée à motif au moyen d'informations reçues à partir de la position déterminée de la première région fortement dopée à motif sur le substrat ; et
le dépôt d'une couche de matière (1432) sur au moins une partie de la première région fortement dopée à motif.

2. Le procédé de la revendication 1, dans lequel l'utilisation de la transformée de Fourier pour traiter l'image optique filtrée comprend :
la création d'une image à transformée de Fourier filtrée en sélectionnant des caractéristiques de la première région fortement dopée de l'image optique filtrée dans un espace de transformée de Fourier et l'élimination par filtrage d'images d'arrière-plan non désirées ; et
la transformation de l'image à transformée de Fourier filtrée pour créer une image finale ayant un contraste plus élevé entre la première région fortement dopée et la deuxième région d'émetteurs dopée au moyen d'une transformée de Fourier inverse.

3. Le procédé des revendications 1 ou 2, dans lequel l'acquisition de l'image optique de la partie de la surface comprend :
la réception de rayonnement électromagnétique depuis la surface à une première longueur d'onde, la première longueur d'onde étant une sous-plage restreinte d'une plage visible ou d'une plage infrarouge.

4. Procédé de formation de cellules solaires à émetteurs sélectifs (1420), comprenant :
le positionnement d'un substrat (1410) sur une surface de réception de substrat, le substrat ayant une surface qui comprend :
au moins une première région (1420) fortement dopée à motif formée sur la surface, ayant une première concentration en dopant qui définit les émetteurs sélectifs, et
une deuxième région (1430) d'émetteurs dopée ayant une deuxième concentration en dopant inférieure à la première concentration en dopant, la deuxième région d'émetteurs dopée entourant la première région fortement dopée à motif ;
la détermination d'une position de la première région fortement dopée à motif sur le substrat, la détermination de la position comprenant :
l'acquisition d'une image optique d'une partie de la surface, l'acquisition de l'image optique incluant la réception de rayonnement électromagnétique depuis la surface à une première longueur d'onde dans un spectre infrarouge de grande longueur d'onde plus longue que, ou égale à, environ 8 µm ;
l'évaluation d'un contraste dans l'image optique entre la première région fortement dopée à motif et la deuxième région d'émetteurs dopée ;
l'alignement d'un ou de plusieurs éléments distinctifs (1 02C) dans un masque de sérigraphie avec la première région fortement dopée à motif au moyen d'informations reçues à partir de la position déterminée de la première région fortement dopée à motif sur le substrat ; et
le dépôt d'une couche de matière (1432) sur au moins une partie de la première région fortement dopée à motif.

5. Le procédé des revendications 1 à 4, dans lequel la surface est formée par un procédé comprenant :
le dépôt d'une première matière dopante (1419) ayant des premiers atomes dopants avec la première concentration en dopant dans un motif sur la surface du substrat ;
le chauffage du substrat et de la première matière dopante pour diffuser les atomes dopants de la première matière dopante dans la surface, et pour former la première région fortement dopée à motif ; et
le dépôt d'une deuxième matière dopante ayant des deuxièmes atomes dopants avec la deuxième concentration en dopant dans les régions entourant la première région fortement dopée à motif pour définir la deuxième région d'émetteurs dopée.

6. Le procédé de la revendication 5, dans lequel les premiers atomes dopants et les deuxièmes atomes dopants sont sélectionnés chacun à partir d'un groupe d'éléments comprenant :
le phosphore, l'arsenic, l'antimoine, le bore, l'aluminium et le gallium.

7. Le procédé des revendications 5 ou 6, dans lequel les premiers atomes dopants et les deuxièmes atomes dopants sont du même type d'atomes dopants.

8. Le procédé des revendications 1 à 7, dans lequel la couche déposée sur la partie de la première région fortement dopée comprend une matière conductrice, le substrat comprend du silicium, et la première concentration en dopant est supérieure à environ 10¹⁸ atomes/cm³.

9. Le procédé des revendications 1 à 8, dans lequel la réception du rayonnement électromagnétique est obtenue au moyen d'un détecteur optique, situé de manière adjacente à la surface.

10. Le procédé des revendications 1 à 9, dans lequel l'acquisition de l'image optique de la partie de la surface comprend :
la fourniture de rayonnement magnétique configuré pour émettre du rayonnement vers la surface.

11. Le procédé de la revendication 10, dans lequel l'acquisition de l'image optique de la partie de la surface comprend en outre :
la détection d'une différence dans une intensité du rayonnement électromagnétique réfléchi par la partie de la première région fortement dopée à motif et de la deuxième région d'émetteurs dopée.

12. Le procédé de la revendication 9, dans lequel la réception de rayonnement électromagnétique depuis la surface du substrat inclut la détection de rayonnement infrarouge émis par le substrat à une température supérieure à la température ambiante.

13. Appareil destiné à la formation de cellules solaires à émetteurs sélectifs, comprenant :
une surface support (138A) configurée pour supporter un substrat (1410) ;
un ensemble détecteur (401) configuré pour acquérir une image optique d'une partie d'une surface du substrat, et configuré pour filtrer l'image optique ;
une chambre de dépôt ayant un masque de sérigraphie et au moins un actionneur configuré pour positionner le masque de sérigraphie ; et
une unité de commande (101) configurée pour :
recevoir l'image optique filtrée,
transformer par transformée de Fourier l'image optique filtrée,
évaluer un contraste entre la première région fortement dopée et la deuxième région d'émetteurs dopée de l'image optique filtrée et de l'image optique transformée par transformée de Fourier, et
aligner une position du masque de sérigraphie (102B) par rapport à une première région (1420) fortement dopée à motif du substrat selon l'évaluation.

14. Appareil destiné à la formation de cellules solaires à émetteurs sélectifs, comprenant :
une surface support (138A) configurée pour supporter un substrat (1410) ;
un ensemble détecteur (401) configuré pour acquérir une image optique d'une partie d'une surface du substrat en recevant du rayonnement électromagnétique depuis la surface, à une première longueur d'onde dans le spectre infrarouge de grande longueur d'onde supérieure ou égale à environ 8 µm ;
une chambre de dépôt ayant un masque de sérigraphie et au moins un actionneur configuré pour positionner le masque de sérigraphie ; et
une unité de commande (101) configurée pour :
recevoir l'image optique depuis l'ensemble détecteur,
évaluer un contraste dans l'image optique entre la première région fortement dopée et la deuxième région d'émetteurs dopée, et
aligner une position du masque de sérigraphie (102B) par rapport à une première région (1420) fortement dopée à motif du substrat selon l'évaluation.

15. L'appareil des revendications 13 ou 14, comprenant en outre :
une source de rayonnement électromagnétique configurée pour émettre du rayonnement électromagnétique vers la surface du substrat.

16. L'appareil tel qu'exposé dans la revendication 13, 14 ou 15, dans lequel l'ensemble détecteur comprend au moins un filtre optique disposé entre la surface et une caméra, le filtre optique étant configuré pour permettre à la première longueur d'onde de le traverser.
